# EUROPEAN PATENT SPECIFICATION

(11) **EP 3 295 246 B1**
(45) Date of publication and mention of the grant of the patent: **01.05.2019**
(21) Application number: 16723468.1
(22) Date of filing: 12.05.2016
(51) Int. Cl.: G03F 7/00, G03F 7/029, G03F 7/20

(54) **METHOD FOR MAKING AN OBJECT**
VERFAHREN ZUR HERSTELLUNG EINES OBJEKTS
PROCÉDÉ DE FABRICATION D'UN OBJET

(30) Priority: 13.05.2015 GB 201508178; 04.08.2015 GB 201513771
(43) Date of publication of application: 21.03.2018
(73) Proprietor: Photocentric Limited, Peterborough, Cambridgeshire PE1 5YW (GB)
(72) Inventor: HOLT, Paul, Peterborough Cambridgeshire PE1 5YW (GB)
(74) Representative: HGF Limited
(86) International application number: PCT/GB2016/051361
(87) International publication number: WO 2016/181149

(56) References cited:
- WO-A1-95/15841
- WO-A1-2007/138356
- WO-A2-02/27408
- US-A1- 2005 072 519

## Description

### Field of the invention

This invention describes a method for making a three dimensional (3D) image by additive manufacturing.

### Background of the invention

3D printing, also known as rapid prototyping or additive manufacturing, is a method of creating three dimensional objects in layers each obtained from a digital representation of the object. Typically an object is scanned in 3 dimensions or generated digitally by computer-aided design (CAD) and split into layers of a specified thickness. These layers are sequentially sent to a 3D printer which constructs each layer of the image, then moves away from the imaging source the platform upon which the 3D object is being created. The platform is moved away from the imaging source by the thickness of one layer. The printer then starts the process of creating the next layer on top of the layer just laid down. There are a number of different types of 3D printing and thus different methods of creating these layers.

This invention lies in the field of stereolithography. Here 3D objects are created in photopolymer (light sensitive resin) by selectively applying electromagnetic radiation to areas of the liquid. Examples of stereolithography are discussed in U.S. patent 4,929,402 to Hull, U.S. patent 4,999,143 to Hull et al., U.S. patent 5,174,931 to Almquist et al and U.S. patent 6,406,658 to Manners et al.. Stereolithographic techniques have been developed that use LCD screens as a light source but typically the light sources in said screens have been replaced with ones which provide greater intensity of light. Because of their high intensity light emission they also emit electromagnetic radiation in the near visible UV region at between 365nm and 400nm. These modifications to the screens increase the cost of the apparatus and may also compromise its longevity, as the screen is being subjected to in use conditions for which it was not designed.

US patent 8,114,569 to Holt describes the use of daylight active photoinitiators incorporated into photopolymer that is active enough to polymerise using commercially available LCD screens (typically computer monitors) as the illuminating source to make a flexographic printing plate (a 3D object comprising two layers: a solid base and an image). US 8,114,569 discloses the use of organic carbonyl compounds, phosphine oxides, titanocene compounds and camphor quinone compounds as photoinitiators activated at a wavelength greater than 370 nm. However, the methods described in the US 8,114,569 did not ultimately provide printing plates of a resolution that was commercially viable. Although it was possible to get a cured representation of the digital image, it was always poor quality, having a rounded upper surface not suitable for making a flexographic printing plate or stamp of saleable quality. The problem with the image seemed to be caused by light diffraction. The images created always varied according to their size, small images would under-expose and large ones overexpose. Modifications to the resin and adjustments to the screen did not obtain results that were of merchandisable quality.

WO95/158411 discloses a 3D printer using an active mask controlled by a computer to selectively polymerise resins.

### Summary of the Invention

In a first aspect of the invention is provided a 3D printer comprising:
a visual display screen; wherein no more than 5% of the light emitted by the screen is UV light;
a vat for liquid photopolymer;
a build platform having a build surface for use in the vat whilst stereolithographically printing a 3D object; and
an actuator for varying the separation of the build surface and the liquid
crystal display screen;
wherein the liquid crystal display screen is situated outside the vat whilst printing a 3D object, and
wherein the vat is transparent to at least part of the spectrum of light that is visible to the human eye or comprises a window that is transparent to at least part of the spectrum of light that is visible to the human eye.

The invention also provides a method for creating a 3-dimensional object using the 3D printer of the first aspect, the method comprising forming more than two layers of a cured polymer by exposing liquid photopolymer to light emitted by a visual display screen, wherein the photopolymer contains a visible light photoinitiator. The screen may be suitable for human viewing. Preferably, there is a single screen. Less than 5% (e.g. less than 0.5%) of the light emitted by the screen is UV light, e.g. it may be that none of the light emitted is UV light. The screen may be an 'off-the-shelf' screen, e.g. a computer screen, monitor, laptop, tablet or mobile phone. The photoinitiator is organometallic or metallocene.

The invention involves the use of a visual display screen as an image source to sequentially create layers which together form solid objects from liquid daylight-active polymer.

The inventor has found that effective 3D images can be created with commercially acceptable levels of resolution using 'off-the-shelf' visual display screens. That the resolution of the 3D images made according to the method of the invention is commercially acceptable is surprising given that the resolution of printing plates made using 'off-the-shelf' visual display screens, photopolymers and photoinitiators was not commercially acceptable. It appears that, when formed in only a thin film (typically 0.2 mm or thinner) the polymer image is an excellent representation of the digital image. This is in contrast to the thicker layers (typically over 1 mm) required in the construction of a printing plate, in which, possibly due to diffraction of light when entering cured polymer, the image becomes curved and loses detail.

The screens used in the methods of the invention may be suitable for human viewing. The screens used in the methods of the invention may emit little or no UV radiation. Using 'off-the-shelf' display screens means that the cost of producing a 3D printer which carries out the method of the invention is lower than it would be if the backlighting of the screen had been replaced with a more intense light. Typically, light sources which offer an increased intensity of light also emit significant amounts of UV light. A 3D printer which carries out the method of the invention might be expected to have a greater longevity than one using a screen with a backlight which has been modified to provide a more intense light source. Screens that emit little or no UV light are inherently safer to the human eye than those that emit a high level of UV light.

Visual display screens used for human viewing emit orders of magnitude less light than the light sources used in existing 3D printers. A normal LCD screen emits of the order of 300cd/m², whereas the typical DLP projector in a 3D printer emits orders of magnitude greater, at around 3000 lumens. This invention is surprising given the lack of intensity of the LCD screen in comparison to existing methods, the only drawback being the longer exposure times required.

It may be that the visual display screen is suitable for human viewing. It may be that the visual display screen is adapted for human viewing. The visual display screen may be an 'off-the-shelf' screen. The visual display screen may be a television monitor, a computer such as a laptop, a mobile device such as a smart phone or a tablet computer. The screen may be unmodified after manufacture.

Less than 5% of the light emitted by the screen is UV light. It may be that less than 2% of the light emitted by the screen is UV light. More preferably it may be that less than 1% (e.g. less than 0.5%) of the light emitted by the screen is UV light. Even more preferably, it may be that less than 0.1% (e.g. less than 0.05%) of the light emitted by the screen is UV light. It may be that no UV light is emitted by the screen. LCD screens manufactured for human viewing are typically illuminated by LED backlights. As LEDs used to backlight LCD screens for human viewing emit across a narrow range of frequencies they have no emissions in the UV region. Visual display screens adapted for human viewing typically emit no light in the UV region. Anything other than negligible amounts of UV radiation is harmful to the human eye. The distribution of wavelengths emitted by a screen will typically be available as a graph as part of the manufacturer's technical data package. Integration of the relevant portions of that graph can be used to determine the proportion of the light emitted which is UV light. The distribution of radiation, and therefore the relative proportions of the components of that radiation, may also be determined using a light meter configured to measure the amount of light emitted across the appropriate ranges of wavelengths.

It may be that the visual display screen has a luminescence of between 100 and 2000 candela per square metre. Thus, it may be that the visual display screen has a luminescence of between 200 to 400 candela per square metre. The luminescence is intended to mean the total luminescence, i.e. the sum of the individual luminescences for UV radiation, visible light, IR radiation, etc. The luminescence of a screen will typically be provided as part of the manufacturer's technical data. It may also be determined using a light meter configured to measure the amount of light emitted across the range of wavelengths emitted by the screen. Thus, the luminescence of an screen can be measured using a luminance meter such as the LS-100 made by Konica. This instrument can provide accurate measurements of the candela / sqm and produce an accurate relative photopic luminosity curve. The test procedure is to turn the screen on for 5 minutes to allow it to reach maximum emission and then in a dark enclosure place the LS-100 on the screen and take the reading in cd/sqm.

The visual display screen may be coated with a low surface energy coating or film (otherwise referred to in this specification as a release layer).

It may be that the coating is the only modification made to said screen. The coating may be a silicone coating, e.g. a polydimethylsiloxane (PDMS) coating. The coating may have a thickness of from 0.1-2 mm, e.g. 0.5-1.5 mm, for example 1 mm.

It may be that a film of transparent plastic is situated on the screen. Thus, in use it may be that the visual display screen is separated from the photopolymer by the film of transparent plastic. The film may be siliconized. The film may be a fluorinated ethylene propylene (FEP) film. The film may have a thickness from 12µm to 250µm, for example 25µm thick. The film may be a perfluoroalkoxy (PFA) film.

It may be that the silicone coating is applied to the base of a rigid transparent tray which sits on the visual display screen.

The term 'transparent' is not intended to mean completely colourless. The film or the base of the tray may be tinted. The term 'transparent' is therefore intended to mean that the transparent object allows light of the wavelengths emitted by the screen when carrying out the methods of the invention to pass. The term transparent may mean that the transparent object allows blue light to pass, e.g. the light emitted by the blue pixels of the visual display screen.

The visual display screen may be a liquid crystal display screen (LCD), e.g. a single LCD screen. The visual display screen may be selected from a light emitting diode type (LED), an organic light emitting diode type (OLED), a polymer light emitting diode type (PLED), an electroluminescent display type (ELD) and a plasma display panel type (PDP). The visual display screen may be a LCD screen (e.g. a single LCD screen) that is backlit by LEDs.

The photoinitiator may be bis(.eta.5-2,4-cylcopentadien-1-yl)-bis(2,6-difluoro-3-(1H-pyrrol-1-yl)-phenyl) titanium.

The method may comprise the steps of (1) forming a first layer of the liquid photopolymer onto a surface; (2) exposing said layer to the light emitted by the visual display screen to form the first layer of cured or partially cured polymer; (3) forming a second layer of the liquid photopolymer onto the first layer of cured or partially cured polymer; (4) exposing said second layer to the light emitted by the visual display screen to form a second layer of cured or partially cured polymer; (5) repeating steps (3) and (4) at least once to build up the three-dimensional object.

Step 3, the step of forming the second layer of photopolymer will typically comprise moving the first layer away from the screen and allowing liquid photopolymer to occupy the space between the first layer and the screen. It may be that the separation of the first layer and the visual display screen is increased monotonically, i.e. the separation of the first layer and the visual display screen is increased between successive exposures by a distance corresponding with a layer thickness of a 3D object to be printed. It may be that the separation of the first layer and the visual display screen is increased between successive exposures by a distance greater than a layer thickness of a 3D object to be formed, and subsequently the separation of the first layer and the visual display screen is reduced by a second distance to provide a net increase in separation corresponding with a layer thickness of a 3D object to be formed. This facilitates the formation of the second layer of the liquid photopolymer in a way that reduces the likelihood of air bubbles which in turn would lead to defects in the resultant 3D object.

Each layer of cured polymer is a 2D image. It represents a cross-section of the completed object. It may be that all layers of cured polymer form different images. It may be that at least 3 of the layers of cured polymer form different images. It may be that at least three adjacent layers of cured polymer form different images. A layer forms a different image from another layer when the two layers have boundaries that do not coincide throughout their whole extent, e.g. they do not coincide to the human eye. A layer forms a different image when the two layers are visibly different in shape and/or size.

The photopolymer may be in direct contact with the visual display screen. The photopolymer may be separated from the visual display screen by a liquid layer. The photopolymer may be separated from the visual display screen by a gaseous layer. The photopolymer may be separated from the visual display screen by a coating or filmic layer, such as those described elsewhere in this specification.

It may be that at least three adjacent layers of the cured polymer are not superimposed throughout the whole extent of each. The three adjacent layers therefore may form different images.

It may be that all of the layers are of the same thickness. It may be that the thickness of each layer is 0.2 mm or less. It may be that the thickness of each layer is 0.15 mm or less. It may be that the thickness of each layer is 0.1 mm or less. It may be that the thickness of each layer is 0.01 mm or greater. It will be understood that layer thickness is subject to manufacturing tolerance, which may cause a microscopic difference in thickness of two layers that would be considered to be of the same thickness.

The photopolymer may comprise at least one stabiliser that prevents degradation of the cured polymer in the 3D object. Exemplary stabilisers include hindered amine light stabilisers. Further exemplary stabilisers include sterically hindered monophenols, e.g. 2,6-di-tert-butyl-p-cresol or butylated hydroxy toluene (BHT). Further exemplary stabilisers include alkylated thiobisphenols, e.g. 2,2-methylenebis-(4-methyl-6-tert-butylphenol) and 2,2- bis (1-hydroxy-4-methyl-6-tert-bytylphenyl) sulfide. The photopolymer may comprise two stabilisers, the stabilisers being 2,6-di-tertiarybutyl-4-methyl phenol and a disubstituted diphenyl amine. Alternatively, the photopolymer may be free of stabilisers. The photopolymer may comprise at least one additional additive selected from dyes, pigments, fillers and plasticizers.

This invention provides significant advantages of cost over current 3D printing systems, in that it utilises low cost mass-produced LCD devices for consumer viewing, however it is an accepted drawback of the invention that it can take longer to produce a fully exposed image than existing systems. However, in addition to the reduction in purchase cost, the energy usage and therefore running costs for the machines of the present invention offer advantages that may outweigh the slower printing times.

It is possible to increase the rate of build by a number of means, not limited to, increasing the rate of reactivity of the polymer, increasing the intensity of the backlight to the LCD screen and increasing the ambient temperature.

### Brief Description of the Drawings

Embodiments of the invention are further described hereinafter with reference to the accompanying drawings, in which:
FIG. 1 shows an exemplary apparatus suitable for carrying out the methods of the invention.
FIG. 2 shows an alternative exemplary apparatus suitable for carrying out the methods of the invention.
FIG. 3 shows products made according to the methods of the invention and in particular according to the Examples.
FIG. 4 shows graphically the time to grow a 0.1mm layer and time required to hold smallest possible detail with different % additions of titanocene (Irgacure 784).

### Detailed description

The wavelength of the light is a length suitable to create polymerisation in the liquid polymer.

The electromagnetic radiation selectively exposes an area of a thin layer of the liquid, solidifying it to form the relevant layer of the shape that is being created. At the end of this process the solidified layer is recoated with more resin and the process is repeated to harden another layer of resin on the previous layer. The process is repeated until the three-dimensional object is complete. The shape of the cured polymer is determined by the shape of the images sequentially created on the screen.

When initially formed, the three-dimensional object may not be fully cured and may require post-curing by heat, immersion in a curative liquid or electromagnetic radiation, or a combination thereof.

Each new layer of cured polymer is formed, therefore, by applying uncured polymer to the previously formed cured layer, e.g. the partially cured layer. The uncured polymer may be applied by lowering the build platform into a vat of the liquid photopolymer and allowing it to cover the previous layer, by spraying the polymer onto the previous layer or by retracting the build platform from the imaging source in a vat of resin or other methods familiar to those skilled in the art. Typically, the object is moved away from the imaging source by a greater distance than a layer then returned to a distance of a single layer. It is possible to retract the build platform in one direction only, away from the imaging source by only the build layer thickness each time.

If new layers are formed at the top surface of the growing object, then after each irradiation step the object under construction is lowered into the vat, a new layer of resin is coated on top and a new irradiation step takes place. An example of this technique is described in U.S. patent 5,236,637 to Hull. In this process the vat or container of liquid polymer must be at least as deep as the tallest object being created. After the final layer has been created the entire object will be below the level of the liquid.

If new layers are formed at the bottom of the growing object, then after each irradiation step, the object under construction must be separated from the bottom print platform in the vat, as a natural attraction will occur. An example of such a technique is described in U.S. patent 5,236,637 to Hull. This technique eliminates the need for a deep vat in which the object is submerged, by instead lifting the object out of a relatively shallow tank. Care should be taken when separating the solidified layer from the bottom print platform due to physical and chemical interactions between the polymer and the base of the container. In small format printers this can attraction can be overcome by the use of low surface energy release layers based on silicone or fluorinated ethylene propylene film or similar.

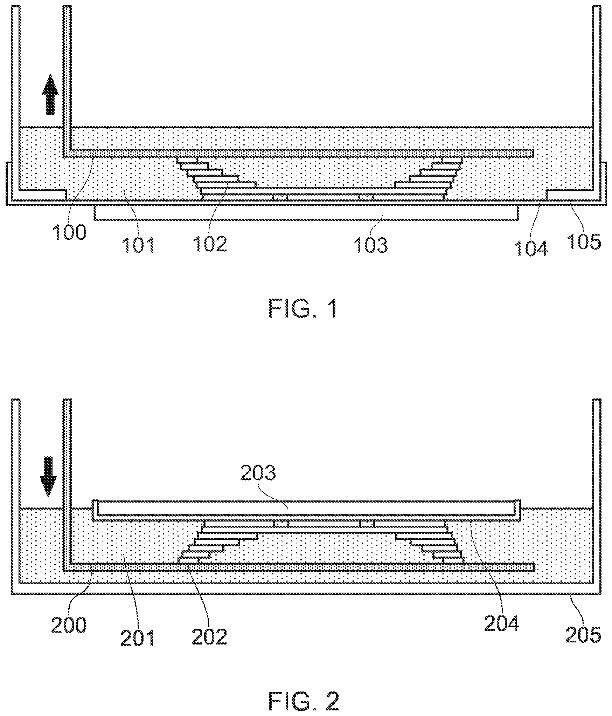

FIG. 1. shows this configuration where **100** is a build platform upon which a 3D object **102** is being built from a liquid polymer **101**, contained in a vat **105**, illuminated with light from an LCD screen **103** which is separated from the polymer by a low surface energy (or release) layer **104**. Here the build platform moves up away from the screen.

FIG. 2. shows the configuration where the build platform **200** supports the 3D object **202** which is built from the liquid polymer **201**, contained in the vat **205**, illuminated with light from the LCD screen **203** which is separated from the polymer by the release layer **204**.

The adhesion of the object to the base of the container occurs in stereo lithographic printers that build from the bottom upwards. U.S. patent 7,438,846 to Hendrik describes a method of overcoming this with an elastic separation layer used to achieve non-destructive separation of solidified material from the bottom print platform.

Commonly a coating that comprises or is polydimethylsiloxane (PDMS) can be applied to the base of the container, usually acrylic sheet. The PDMS coating creates a thin lubricating film of un-polymerized resin through its action as a polymerization inhibitor. This is thought to be caused by ability for silicones to retain oxygen in their surface which is a known inhibitor of photoinitiation. Alternatively, another polymerisation inhibitor, stabiliser or a combination of them may be applied to the base of the container.

It is also possible to use low surface energy films tightened over a frame or open-bottomed tray. These films can be any clear plastic such as polypropylene, polyester, polycarbonate, polyethylene etc with silicone particles that are grafted or nano-coated onto their surface. It is also possible to use transparent polytetrafluoroethylene (PTFE), a perfluoroalkoxy copolymer (PFA) film, a ethylene-chloro-trifluoro-ethylene film (ECTFE), a copolymer of ethylene & tetrafluoroethylene (ETFE) film, a polyvinylidene fluoride (PVDF) film.

It is possible to use a FEP film as the release layer applied tightly to a frame which also acts as the vat.

U.S. patent 5,569,349 to Almquist et al. discloses an apparatus and method for providing 3D objects through the principles of stereolithography using flowable materials. This patent also describes the use of support materials that are easily removable from the finished part. The apparatus directs a nozzle to selectively dispense polymer in the desired areas to form the object. The flow is then blocked, allowing the material to harden, and the next section is formed in the same manner. If the object requires support, a second material such as a wax, thermoplastic or hot melt glue can be used to fill the voids. By using a second material with a different melting point, the second material can be readily removed from the final part.

Stereolithographic 3D printers typically require relatively low viscosity polymer to enable the new layer of liquid polymer coating the object to be applied evenly and easily. This viscosity may be less than 5,000 cps at 25°C and desirably less than 500 cps at 25°C. In practice as low a viscosity as possible is advantageous for ease of recovering the build platform.

The use of photoinitiators in 3D printing that are responsive to visible light has been described in EP 2502728 to Kangtai et al. This describes light sources emitting visible light e.g., from about 475 nm to about 900 nm and gives examples of suitable photoinitiators that include: camphorquinone, 4,4'- bis(diethylamino) benzophenone, 4,4'-bis(N,N'-dimethylamino) benzophenone, bis(2,4,6-trimethylbenzoyl)-phenylphosphineoxide, metallocenes such as bis(ela 5-2-4-cyclopentadien-1-yl)bis[2,6-difluoro-3-(1H-pyrrol-1-yl)phenyl] titanium, and the visible light photo initiators from Spectra Group Limited, Inc. such as H-Nu 470, H-Nu-535, H-Nu-635, H-Nu-Blue-640, and H-Nu-Blue-660.

Photoinitiators used in 3D printing typically act by free radical transfer or by cationic transfer of light energy. The polymers used in 3D printing, sometimes also referred to as resins, inks or polymers, are typically either urethane acrylate or epoxy acrylate chemistry. Urethane acrylates can include monomers and/or free radical polymerizable monomers, and a suitable initiator such as a free radical initiator, and combinations thereof. Examples include, but are not limited to, acrylics, methacrylics, acrylamides, styrenics, olefins, halogenated olefins, cyclic alkenes, maleic anhydride, alkenes, alkynes, carbon monoxide, functionalized oligomers, functionalized polyethylene glycols, etc., including combinations thereof. Examples of liquid resins, monomers and initiators include, but are not limited to those described in U.S. patent 8,232,043 to Bishop, which references the use of liquid bis(acyl)phosphine oxide as a photoinitiator.

In some embodiments the polymerizable liquid comprises a free radical polymerizable liquid in which case an inhibitor may be oxygen, in other embodiments the polymerizable liquid comprises an acid catalyzed, or cationically polymerized polymerizable liquid. In such embodiments the polymerizable liquid comprises monomers containing groups suitable for acid catalysis, such as epoxide groups and vinyl ether groups. Suitable monomers include olefins such as methoxyethene, 4-methoxystyrene, styrene, 2-methylprop-1-ene, 1,3- butadiene, etc.; heterocyclic monomers (including lactones, lactams, and cyclic amines) such as oxirane, thietane, tetrahydrofuran, oxazoline, 1,3, dioxepane, oxetan-2-one, etc., and combinations thereof. A suitable photoacid generator (PAG) is included in the acid catalyzed polymerizable liquid, examples of which include, but are not limited to onium salts, sulfonium and iodonium salts, etc., such as diphenyl iodide hexafluorophosphate, diphenyl iodide hexafluoroarsenate, diphenyl iodide hexafiuoroantimonate, diphenyl p-methoxyphenyl triflate, diphenyl p-toluenyl triflate, diphenyl p-isobutylphenyl triflate, diphenyl p-tert-butylphenyl triflate, triphenylsulfonium hexafluororphosphate, triphenylsulfonium hexafluoroarsenate, triphenylsulfonium hexafiuoroantimonate, triphenylsulfonium triflate, dibutylnaphthylsulfonium triflate, etc., including mixtures thereof. U.S. patent 7,824,839 to Ober et al. describes various PAGs.

Preferably, the screen used in the methods of the invention is an LCD screen. An LCD typically consists of an array of pixels. Each pixel consists of a layer of liquid crystal molecules aligned between two transparent electrodes and two polarizing filters (parallel and perpendicular), the axes of transmission of which are, in most of the cases, perpendicular to each other. Before an electric field is applied, the orientation of the liquid-crystal molecules is determined by the alignment at the surfaces of electrodes. In the most commonly used twisted nematic device, the surface alignment directions at the two electrodes are perpendicular to each other and so the molecules arrange themselves in a helical structure. This induces the rotation of the polarization of the incident light, and the device appears grey. If the applied voltage is large enough, the liquid crystal molecules in the centre of the layer are almost completely untwisted and the polarization of the incident light is not rotated as it passes through the liquid crystal layer. This light will then be mainly polarized perpendicular to the second filter, and thus be blocked and the pixel will appear black. By controlling the voltage applied across the liquid crystal layer in each pixel, light can be allowed to pass through in varying amounts thus constituting different levels of grey.

Other than the visual display screen, the apparatus of the 3D printer used in this invention may in principle be the same as any machine commonly used in stereo lithographic printers. The process of creating the layers may in principle be the same as in existing stereolithography systems, but has been modified for the invention. Thus, the invention provides an apparatus for creating a 3-dimensional object (i.e. a 3D printer), the apparatus comprising:
a visual display screen; wherein no more than 5% of the light emitted by the screen is UV light;
a vat for liquid photopolymer;
a build platform having a build surface for use in the vat whilst stereolithographically printing a 3D object; and
an actuator for varying the separation of the build surface and the liquid crystal display screen;
wherein the liquid crystal display screen is situated outside the vat whilst printing a 3D object, and
wherein the vat is transparent to at least part of the spectrum of light that is visible to the human eye or comprises a window that is transparent to at least part of the spectrum of light that is visible to the human eye.

The apparatus may also comprise an image processor configured to control the visual display screen to display a sequence of photolithographic images. The apparatus may also comprise an actuation controller configured to control the actuator; wherein the image processor and actuation controller are configured to communicate to synchronise the display of photolithographic images and the varying the separation of the build surface and the visual display screen. It may be that the actuation controller is configured to monotonically increase the separation of the build surface and the visual display screen between successive stereolithographic exposures by a distance corresponding with a layer thickness of a 3D object to be printed. Alternatively, it may be that the actuation controller is configured to increase the separation of the build surface and the visual display screen between successive stereolithographic exposures by a distance greater than a layer thickness of a 3D object to be formed, and subsequently to reduce the separation by a second distance to provide a net increase in separation corresponding with a layer thickness of a 3D object to be formed. Where the screen forms part of a handheld device, the actuation controller that controls the actuator could be the processor in the handheld device (i.e. same processor as the image processor), or it could be a separate part of the printer, which communicates with the phone's processor to synchronise varying the separation and making the image exposures.

Further embodiments of the apparatus of the invention, and particularly of the visual display screen, are described elsewhere in this specification. In particular, it may be that the visual display screen is a liquid crystal display screen (LCD). It may be that the visual display screen is a single LCD screen. It may be that the visual display screen is backlit by LEDs. It may be that the visual display screen is selected from a light emitting diode type (LED), an organic light emitting diode type (OLED), a polymer light emitting diode type (PLED), an electroluminescent display type (ELD), and a plasma display panel type (PDP).

It may be that the a visual display screen is situated outside the vat whilst stereolithographically printing a 3D object, and the vat is transparent to at least part of the spectrum of light that is visible to the human eye or comprises a window that is transparent to at least part of the spectrum of light that is visible to the human eye. The build platform may comprise a plate having a surface, said surface being the build surface. The plate is typically made of a substance that has a considerably higher affinity for photopolymers than the base of the vat. The plate may, for example, be a glass plate. The plate is typically the same shape as the base of the vat. The plate may be the same size as the base of the vat. The plate may be slightly smaller than the base of the vat, e.g. from 85%-99% as large in one or all dimensions compared to the base of the vat.

The standard process of creating a 3D image is to take a digital 3D image using computer aided design /computer aided manufacturing (CAD/CAM) software, for example, Google's SketchUp or Caligari Corp's Truespace, which will then split this design into layers, typically 0.1mm or smaller. It then sends a digital image of this layer to a display apparatus, in this case an LCD screen.

The length of time that the screen illuminates the image is determined by the rate of cure of the polymer. It is desirable that it is as short as time as possible, typically a number of seconds from 1 to 2520 seconds, more typically from 20 to 220 seconds or from 50 to 180 seconds. While exposure times of from 1 to 50 seconds (e.g. from 1 to 20 second) can generate images suitable for certain applications, these images are often underexposed for many applications. This invention typically uses longer times of the order of 60 to 180 seconds per layer 0.1mm thick. Typically existing SLA machines require between 4 and 20 seconds to build a layer 0.1mm thick. At the end of the illuminating sequence the print platform will move away from the screen in order to provide a space for the new layer to be created.

In practice it can be desirable to move the platform further away from the screen than the layer thickness to allow easy and fast passage of the polymer back into the gap. Here the platform will typically move away by the distance of small number of layers and then can optionally wait for a dwell time of a few seconds before returning to the separation distance of one build layer from the screen.

There are other methods used to enable easy screen detachment and to allow resin to flow back. It is possible to move the print platform away from the screen at an angle so the peel area is a line rather than the entire build area. It is possible that the build platform itself bends or is hinged so the detachment force is applied at an angle to the screen. It is possible to use a flexible inner lamina of transparent film that can be peeled back from the screen surface. It is also possible to inject resin to separate the platform from the screen with jets of liquid resin. The method of screen detachment is not critical to this invention and is not limited to these examples.

Typically the photosensitive resin is filled into a vat. The object will be created on a build platform which is immersed in the vat. The build platform can be moved in the vertical plane inside that vat of polymer. The build platform may be made from a light, strong and flexible material, suitably aluminium, stainless steel or rigid plastic. The build platform is typically made of a substance that has a considerably higher affinity for photopolymers than the base of the vat. The build platform may, for example, be made of glass. The surface of the build platform should be a material that the polymer will grow onto easily. The surface of the material may thus be roughened. It has been found that the good results can be obtained from using anodised aluminium with a surface that was slightly roughened. Alternatively the build platform could be formed from the same daylight active polymer that is used to make the 3D objects. In practice it has been found that it is desirable to exposes a number of solid layers first typically between 2 and 5 that will become an active base layer to grow the structure from.

Any suitable polymerisable compound can be used to construct the photopolymer in this invention. The photopolymer is typically a urethane acrylate or an epoxy acrylate, but could be any compound that is polymerisable under electromagnetic radiation. In this process a photopolymer was created by combining urethane oligomers with reactive monomers and photoinitiators. The photopolymer resin used in the formulation can be manufactured in a variety of manners known by anyone skilled in the art. The critical aspect is the addition of the correct photoinitiators in the correct concentrations so that they have the ability to absorb in the visible region of the electromagnetic spectrum and pass that energy on. The level of the photoinitiators can be at an amount, for example, from 0.1% to 10% by weight and more typically at levels of from 0.3 to 2.5% (e.g. from 0.3 to 1.3% or from 0.3 to 0.7%). More preferably, the photoinitiators will be present at an amount of from 0.7 to 1.5%, the percentages being calculated by weight of the total liquid photopolymer. It is desirable that the cure speed of the reaction is adjusted so that the rate of growth is as fast as practical. The rate of cure will determine the programmed time to create a layer of the desired thickness in the apparatus.

Experimentation has shown that organometallic and metallocene photoinitiators are suitable for the invention. These photoinitiators react mainly to the photons emitted from the blue pixels of the visual display screen. Other initiators tried so far have been unsuitable.

Examples of suitable photoinitiators in certain embodiments include titanocene compounds, e. g.bis(cyclopentadienyl)titanium dichloride, bis(cyclopentadienyl)diphenyltitanium, bis(cyclopentadienyl)bis(2,3,4,5,6-pentafluorophen-1-yl)titanium, bis(cyclopenta-dienyl)bis(2,3,5,6-tetrafluorophen-1-yl)titanium, bis-(cyclopentadienyl) bis(2,4,6-trifluoropheny-1-yl)titanium, bis(cyclopentadienyl)bis(2,6-difluorophen-1-yl)titanium, bis(cyclopentadienyl)bis(2,4-difluorophen-1-yl)titanium, bis(methylcyclopenta-dienyl)bis(2,3,4,5,6-pentafluorophen-1-yl)titanium, bis(methyl-cycxlopentadienyl)-bis(2,3,5,6-tetrafluorophen-1-yl)titanium, bis(methylcyclopenta-dienyl)bis(2,4-difluoropheny-1-yl)titanium, bis(cyclopentadienyl)bis[2,6-difluoro-3-(pyr-1-yl)phenyl]titanium, bis(cyclopentadienyl)bis[2,6-difluoro-3-(methylsulfonamido)-phenyl]titanium, bis(cyclopentadienyl)bis[2,6-difluoro-3-(N-butylbiaroylamino)-phenyl]titanium, bis(cyclopentadienyl)bis[2,6-difluoro-3-(N-ethylacetylamino)phenyl]-titanium, bis(cyclopentadienyl)bis[2,6-difluoro-3-(N-methylacetylamino)phenyl]-titanium, bis(cyclopentadienyl)bis[2,6-difluoro-3-(N-ethylpropionylamino)phenyl]-titanium, bis(cy-clopentadienyl)bis[2,6-difluoro-3-(N-ethyl-(2,2-dimethylbutanoyl)-amino)phenyl]-titanium, bis(cyclopentadienyl)bis[2,6-difluoro-3-(N-butyl-(2,2-dimethyl-butanoyl)-amino)phenyl-]titanium, bis(cyclopentadienyl)bis[2,6-difluoro-3-(N-pentyl-(2,2-dimethyl-butanoyl)amino)phenyl]titanium, bis(cyclopentadienyl)bis[2,6-difluoro-3-(N-hexyl)-(2,2-dimethylbutanoyl)phenyl]titanium, bis(cyclopentadienyl)bis[2,6-difluoro-3-(N-methylbutyrylamino)phenyl]titanium, bis(cyclopentadienyl)bis[2,6-difluoro-3-(N-methylpentanoylamino)phenyl]titanium, bis(cyclopentadienyl)bis[2,6-difluoro-3-(N-ethylcyclohexylcarbonylamino)phenyl]titanium, bis(cyclopentadienyl)-bis[2,6-difluoro-3-(N-ethylisobutyrylamino)phenyl]titanium, bis(cyclopentadienyl)-bis[2,6-difluoro-3-(2,2,5,5-tetramethyl-1,2,5- -azadisilolidin-1-yl)phenyl]titanium, bis-(cyclopentadienyl)bis[2,6-difluoro-3-(octylsulfonamido)phenyl]titanium bis(cyclopentadienyl)bis[2,6-difluoro-3-(4-tolylsulfonamido)phenyl]titanium, bis(cyclopentadienyl)-bis[2,6-difluoro-3-(4-dodecylphenylsulfonylamido)- phenyl]titanium, bis(cyclopentadienyl)bis[2,6-difluoro-3-(4-(1-pentylheptyl)phenylsulfonyl-amido)phenyl]titanium, bis-(cyclopentadienyl)bis[2,6-difluoro-3-(ethylsulfonylamido)phenyl]titanium, bis(cyclo-pentadienyl)bis[2,6-difluoro-3-((4-bromophenyl)sulfonylamido)-phenyl]titanium, bis(cyclopentadienyl)bis[2,6-difluoro-3-(2-naphthylsulfonylamido)phenyl]titanium, bis-(cyclopentadienyl)bis[2,6-difluoro-3-(hexadecylsulfonylamido)phenyl]titanium, bis-(cyclopentadienyl)bis[2,6-difluoro-3-(N-methyl-(4-dodecylphenyl)sulfonylamido)-phenyl-]titanium, bis(cyclopentadienyl)bis[2,6-difluoro-3-(N-methyl-4-(1-pentylheptyl)-phenyl)sulfonylamido)]titanium, bis(cyclopentadienyl)bis[2,6-difluoro-3-(N-hexyl-(4-tolyl)sulfonylamido)phenyl]titanium, bis(cyclopentadienyl)bis[2,6-difluoro-3-(pyrrolidine-2,5-dion-1-yl)phenyl-]titanium, bis(cyclopentadienyl)bis[2,6-difluoro-3-(3,4-dimethyl-3-pyrroli-dine-2,5-dion-1-yl)phenyl]titanium, bis(cyclopentadienyl)- bis[2,6-difluoro-3-(phthalimido)phenyl]titanium, bis(cyclopentadienyl)bis[2,6-difluoro-3-isobutoxycarbonylamino)phenyl]titanium, bis(cyclopentadienyl)bis[2,6-difluoro-3-(ethoxycarbonylamino)phenyl-]titanium, bis(cyclopentadienyl)bis[2,6-difluoro-3-((2-chloroethoxy)carbonylamino)phenyl]titanium, bis(cyclopentadienyl)bis[2,6-difluoro-3-(phenoxycarbonylamino)phenyl]titanium, bis(cyclopentadienyl)bis[2,6-difluoro-3-(3-phenylthioureido)phenyl]titanium, bis(cyclopentadienyl)bis[2,6-difluoro-3-(3-butyl-thioureido)phenyl-]titanium, bis(cyclopentadienyl)bis[2,6-difluoro-3-(3-phenylureido)-phenyl]- titanium, bis(cyclopentadienyl)bis[2,6-difluoro-3-(3-butylureido)phenyl]tit-anium, bis(cyclopentadienyl)bis[2,6-difluoro-3-(N,N-diacetylamino)phenyl]- titanium, bis(cyclopentadienyl)bis[2,6-difluoro-3-(3,3-dimethylureido)phenyl]titanium, bis(cyclo-pentadienyl)bis[2,6-difluoro-3-(acetylamino)phenyl]titanium, bis(cyclopentadienyl)-bis[2,6-difluoro-3-(butyrylamino)phenyl]titanium, bis(cyclopentadienyl)bis[2,6-difluoro-3-(decanoylamino)phenyl]titanium, bis(cyclopentadienyl)bis[2,6-difluoro-3-(octadecanoylamino)phenyl]titanium, bis(cyclopentadienyl)bis[2,6-difluoro-3-(isobutyrylamino)phenyl]titanium, bis(cyclopentadienyl)bis[2,6-difluoro-3-(2-ethylhexanoylamino)phenyl]titanium, bis(cyclopentadienyl)bis[2,6-difluoro-3-(2-methylbutanoylamino)phenyl]titanium, bis(cyclopentadienyl)bis[2,6-difluoro-3-(pivaloylamino)-phenyl]titanium, bis(cyclopentadienyl)bis[2,6-difluoro-3-(2,2-dimethylbutanoylamino-)phenyl-]titanium, bis(cyclopentadienyl)bis[2,6-difluoro-3-(2-ethyl-2-methyl-heptan-oylamino)phenyl]titanium, bis(cyclopentadienyl)bis[2,6-difluoro-3-(cyclohexylcar-bonylamino)phenyl]titanium, bis(cyclopentadienyl)bis [2,6-difluoro-3-(2,2-dimethyl-3-chloropropanoylamino)phenyl]titanium, bis(cyclopentadienyl)bis[2,6-difluoro-3-(3-phenylpropanoylamino)phenyl]titanium, bis(cyclopentadienyl)bis[2,6-difluoro-3-(2-chloromethyl-2-methyl-3--chloropropanoylamino)phenyl]titanium, bis(cyclopenta-dienyl)bis[2,6-difluoro-3-(3,4-xyloylamino)phenyl]titanium, bis(cyclopentadienyl)bis-[2,6-difluoro-3-(4-ethylbenzoylamino)phenyl]titanium, bis(cyclopentadienyl)bis[2,6-difluoro-3-(2,4,6-mesitylcarbonylamino)phenyl]titanium, bis(cyclopentadienyl)-bis[2,6-difluoro-3-(benzoylamino)phenyl]titanium, bis(cyclopentadienyl)bis[2,6-difluoro-3-(N-(3-phenylpropyl)benzoylamino)phenyl]titanium, bis(cyclopentadienyl)bis[2,6-difluoro-3-(N-(3-ethylheptyl)-2,2-dimethylpentanoylamino)phenyl]titanium, bis(cyclopentadienyl)bis[2,6-difluoro-3-(N-isobutyl-(4-toluyl)amino)phenyl]titanium, bis(cyclopentadienyl)bis[2,6-difluoro-3-(N-isobutylbenzoylamino)phenyl]titanium, bis(cyclopentadienyl)bis[2,6-difluoro-3-(N-cyclohexylmethylpivaloy-lamino)phenyl]titanium, bis-(cyclopentadienyl)bis[2,6-difluoro-3-(N-(oxolan-2-ylmethyl)benzoylamino)phenyl]-titanium, bis(cyclopentadienyl)bis[2,6-difluoro-3-(N-(3-ethylheptyl)-2,2-dimethyl-butanoylamino)phenyl]titanium, bis(cyclopentadienyl)bis[2,6-difluoro-3-(N-(3-phenyl-propyl-(4-toluyl)amino)phenyl]titanium, bis(cyclopentadienyl)bis[2,6-difluoro-3-(N-(oxolan-2-ylmethyl)-(4-toluyl)-amino)phenyl)titanium, bis(cyclopentadienyl)bis[2,6-difluoro-3-(N-(4-toluylmethyl)benzoylamino)phenyl]titanium, bis(cyclopentadienyl)-bis[2,6-difluoro-3-(N-(4-toluylmethyl)-(4-toluyl)amino)phenyl]titanium, bis(cyclopentadienyl)bis[2,6-difluoro-3-(N-butylbenzoylamino)phenyl]titanium, bis(cyclopentadienyl)bis[2,6-difluoro-3-(N-butyl-(4-toluyl)amino)phenyl]titanium, bis(cyclopentadienyl)bis[2,6-difluoro-3-(N-hexyl-(4-toluyl)amino)phenyl]titanium, bis(cyclopentadienyl)bis[2,6-difluoro-3-(N-(2,4-dimethylpentyl)-2- ,2-dimethylbutanoylamino) phenyl]titanium, bis(cyclopentadienyl)bis[2,6-difluoro-3-(2,4-dimethylpentyl)-2,2-dimethyl-pentanoylamino)phenyl]titanium, bis(cyclopentadienyl)bis[2,6-difluoro-3-((4-toluyl)amino)phenyl]titanium, bis(cyclopentadienyl)bis[2,6-difluoro-3-(2,2-dimethyl-pentanoylamino)phenyl]titanium, bis(cyclopentadienyl)bis[2,6-difluoro-3-(2,2-dimethyl-3-ethoxypropanoylamino)phenyl]titanium, bis(cyclopentadienyl)bis[2,6-difluoro-3-(2,2-dimethyl-3-allyloxypropanoylamino)phenyl]titanium, bis(cyclopentadienyl)bis[2,6-difluoro-3-(N-allylacetylamino)phenyl]titanium, bis(cyclopentadienyl)bis[2,6-difluoro-3-(2-ethylbutanoylamino)phenyl]titanium, bis(cyclopentadienyl)bis(2,6-difluoro-3-(N-cyclohexylmethylbenzoy-lamino)phenyl]titanium, bis-(cyclopentadienyl)bis[2,6-difluoro-3-(N-cyclohexylmethyl-(4-toluyl)amino)phenyl]-titanium, bis(cyclopentadienyl)bis[2,6-difluoro-3-(N-(2-ethylhexyl)benzoylamino)-phenyl]titanium, bis(cyclopentadienyl)bis[2,6-difluoro-3-(N-isopropylbenzoylamino-)phenyl]titanium, bis(cyclopentadienyl)bis[2,6-difluoro-3-(N-phenylpropyl)-2,2-dimethylpentanoyl)amino)phenyl]titanium, bis(cyclopentadienyl)bis[2,6-difluoro-3-(N-hexylbenzoylamino)phenyl]titanium, bis(cyclo-pentadienyl)bis[2,6-difluoro-3-(N-cyclohexylmethyl-2,2-dimethylpentanoyl)amino)phenyl-]titanium, bis(cyclopeantadienyl)bis[2,6-difluoro-3-(N-butylbenzoyl-amino)-phenyl]titanium, bis(cyclopentadienyl)bis[2,6-difluoro-3-(N-(2-ethylhexyl)-2,2-dimethylpentanoyl)amino)phenyl]-titanium, bis(cyclopentadienyl)bis[2,6-difluoro-3-(N-hexyl-2,2-dimethylpentanoyl-amino)phenyl]titanium, bis(cyclopentadienyl)bis[2,6-difluoro-3-(N-isopropyl-2,2-dimethylpentanoylamino)phenyl]titanium, bis(cyclopentadienyl)bis[2,6-difluoro-3-(N-3-phenylpropyl)pivaloylamino)phenyl]titanium, bis(cyclo-pentadienyl)bis[2,6-difluoro-3-(N-butyl-2,2-dimethylpentanoylamino)phenyl]titanium, bis (cyclopentadienyl)bis[2,6-difluoro-3-(N-(2-methoxyethyl)benzoylamino)phenyl]titanium, bis(cyclopenta-dienyl)bis[2,6-difluoro-3-(N-benzylbenzoylamino)phenyl]titanium, bis-(cyclopenta-dienyl)bis[2,6-difluoro-3-(N-benzyl-(4-toluyl)amino)phenyl]titanium, bis-(cyclopean-tadienyl)bis[2,6-difluoro-3-(N-(2-methoxyethyl)-(4-toluyl)amino)phenyl-]titan-ium, bis-(cyclopentadienyl)bis[2,6-difluoro-3-(4-methylphenylmethyl)-2,2-dimethyl-pentanoylamino)phenyl]titanium, bis(cyclopentadienyl)bis [2,6-difluoro-3-(N-(2-methoxyethyl)-2,2-dimethylpentanoylamino)phenyl]titanium, bis(cyclopentadienyl) bis[2,6-difluoro-3-(N-cyclohexylmethyl-(2-ethyl-2-methylheptanoyl)aminophenyl]titanium, bis(cyclo-pentadienyl)bis[2,6-difluoro-3-(N-butyl-(4-chlorobenzoyl)amino)phenyl]titanium, bis-(cyclopentadienyl)bis[2,6-difluoro-3-(N-hexyl-(2-ethyl-2-methylbutanoyl-)amino)-phenyl]titanium, bis(cyclopentadienyl)bis[2,6-difluoro-3-(N-cyclohexyl-2,2-dimethyl-pentanoylamino)phenyl]titanium, bis(cyclopentadienyl)bis[2,6-difluoro-3-(N-(oxolan-2-ylmethyl)-2,2-dimeth-ylpentanoyl)amino)phenyl]titanium, bis(cyclopentadienyl)-bis-[2,6-difluoro-3-(N-cyclohexyl-(4-chlorobenzoyl)am- ino)phenyl]titanium, bis(cyclo-pentadienyl)bis[2,6-difluoro-3-(N-cyclohexyl-(2-chlorobenzoyl)amino)phenyl]titanium, bis(cyclopentadienyl)bis[2,6-difluoro-3-(3,3-dimethyl-2-azetidinon-1-yl)phenyl]tit-anium, bis(cyclopentadienyl)bis(2,6-difluoro-3-isocyanatophenyl)titanium, bis(cyclo-pentadienyl)bis[2,6-difluoro-3-(N-ethyl-(4-tolylsulfonyl)amino)phenyl]titanium, bis-(cyclopentadienyl)bis[2,6-difluoro-3-(N-hexyl-(4-tolylsulfonyl)amino)phenyl]titanium, bis(cyclopentadienyl)bis[2,6-difluoro-3-(N-butyl-(4-tolylsulfonyl)amino)phenyl]titanium, bis(cyclopentadienyl)bis[2,6-difluoro-3-(N-isobutyl-(4-tolylsulfonyl)amino)phenyl]-titanium, bis(cyclopentadienyl)bis[2,6-difluoro-3-(N-butyl-(2,2-dimethyl-3-chloropropanoyl)amino)phenyl]titanium, bis(cyclopentadienyl)bis[2,6-difluoro-3-(N-(3-phenylpropanoyl)-2,2-dimethyl-3-chloropropanoyl)amino)phenyl]titanium, bis(cyclopentadienyl)bis[2,6-difluoro-3-(N-cyclohexylmethyl-(2,2-dimethyl- -3-chloro-propanoyl)amino)phenyl]titanium, bis(cyclopentadienyl)bis[2,6-difluoro-3-(N-isobutyl-(2,2-dimethyl-3-chloropropanol)phenyl]titanium, bis(cyclopentadienyl)bis[2,6-difluoro-3-(N-butyl-(2-chloromethyl-2-methyl- -3-chloropropanoyl)amino)phenyl]titanium, bis(cyclo-pentadienyl)bis[2,6-difluoro-3-(butylthiocarbonylamino)phenyl]titanium, bis(cyclo-pentadienyl)bis[2,6-difluoro-3-(phenylthiocarbonylamino)phenyl)titanium, bis(methyl-cyclopentadienyl)bis[2,6-difluoro-3-(N-hexyl-2,2-dimethylbutanoyl)amino-)phenyl]tit-anium, bis(methylcyclopentadienyl)bis[2,6-difluoro-3-(N-hexyl-2,2-dimethylpenta-noylamino)phenyl)titanium, bis(methylcyclopentadienyl)bis[2,6-difluoro-3-(N-ethyl-acetytlamino)phenyl-]titanium, bis(methylcyclopentadienyl)bis[2,6-difluoro-3-(N-ethylpropionylamino)phenyl]titanium, bis(trimethylsilylpentadienyl)bis[2,6-difluoro-3-(N-butyl-2,2-dimethylpro-panoylamino)phenyl]titanium, bis(cyclopentadienyl)bis[2,6-difluoro-3-(N-(2-methoxyethyl)-trimethylsilylamino)phenyl]titanium, bis(cyclopentadienyl)bis[2,6-difluoro-3-(N-butylhexyldimethylsilylamino)phenyl]titanium, bis(cyclopentadienyl)bis[2,6-difluoro-3-(N-ethyl-(1,1,2-trimethylpropyl)dimethylsilylamino)-phenyl]titanium, bis(cyclopentadienyl)bis[2,6-difluoro-3-(3-ethoxymethyl-3-methyl-2-azethi- odinon-1-yl)phenyl]titanium, bis(cyclopentadienyl)bis[2,6-difluoro-3-(3-allyloxymethyl-3-methyl-2-azet-idinon-1-yl)phenyl]titanium, bis(cyclopentadienyl)bis[2,6-difluoro-3-(3-chloromethyl-3-methyl-2-azetid-inon-1-yl)phenyl]titanium, bis(cyclopentadienyl)bis[2,6-difluoro-3-(N-benzyl-2,2-dimethylpropanoylamino)phenyl]titanium, bis(cyclopentadienyl)bis[2,6-difluoro-3-(5,5-dimethyl-2-pyrrodininon-1-yl-)phenyl-]titanium, bis(cyclopentadienyl)bis[2,6-difluoro-3-(6,6-diphenyl-2-piperidinon-1-yl)-phenyl]titanium, bis(cyclopentadienyl)bis[2,6-difluoro-3-(N-(2,3-dihydro-1,2-benzo-isothiaz- ol-3-one(1,1-dioxide)-2-yl)phenyl]titanium, bis(cyclopentadienyl)bis[2,6-difluoro-3-(N-hexyl-(4-chlorobenzoyl)amino)phenyl]titanium, bis(cyclopenta-dienyl)-bis[2,6-difluoro-3-(N-hexyl-(2-chlorobenzoyl)amino)phenyl]titanium, bis(cyclopentadienyl)bis[2,6-difluoro-3-(N-isopropyl-(4-chlorobenzoyl)amino)phenyl]titanium, bis-(cyclopentadienyl)bis[2,6-difluoro-3-(N-(4-methylphenylmethyl)-(4-chlorobenzoyl)-amino)phenyl]titanium, bis(cyclopentadienyl)bis[2,6-difluoro-3-(N-(4-methylphenylmethyl)-(2-chlorobenzoyl)amino)phenyl]titanium, bis(cyclopentadienyl)bis[2,6-difluoro-3-(N-benzyl-2,2-dimethylpentanoylamino)phenyl]titanium, bis(cyclopentadienyl)bis[2,6-difluoro-3-(N-(2-ethylhexyl)-4-tolyl-sulfonyl)amino)phenyl]titanium, bis(cyclopenta-dienyl)bis[2,6-difluoro-3-(N-(3-oxaheptyl)benzoylamino)phenyl-]titanium, bis(cyclopenta-dienyl)bis[2,6-difluoro-3-(N-(3,6-dioxadecyl)benzoylamino)phenyl]titanium, bis(cyclo-pentadienyl)bis[2,6-difluoro-3-(trifluoromethylsulfonyl)amino)phenyl]titanium, bis(cyclo-pentadienyl)bis[2,6-difluoro-3-(trifluoroacetylamino)phenyl]titanium, bis(cyclo-pentadienyl)bis[2,6-difluoro-3-(2-chlorobenzo-yl)amino)phenyl]titanium, bis(cyclo-pentadienyl)bis[2,6-difluoro-3-(4-chlorobenzoyl)-amino)phenyl]titanium, bis(cyclo-pentadienyl)bis[2,6-difluoro-3-(N-(3,6-dioxadecyl)-2,2-dim- ethylpenta-noylamino)phenyl]titanium, bis(cyclopentadienyl)bis[2,6-difluoro-3-(N-(3,7-dimethyl-7-methoxyoctyl)benzoylamino)phenyl]titanium, and bis(cyclopentadienyl)bis[2,6difluoro-3-(N-cyclohexylbenzoylamino)phenyl]titanium.

In certain embodiments, the composition further comprises an activator which can be used together with a photoinitiator to enhance curing efficiency. In one embodiment, the activators may comprise tertiary amine and sulfinate compounds. Examples of activators which could be used in the present invention include, but are not limited to, e.g. ethyl 4-(N,N-dimethylamino) benzoate, 2-(ethylhexyl)-4-(N,N-dimethylamino) benzoate, N,N-dimethylaminoethyl methacrylate, N,N-dimethylaminophenethyl alcohol, sodium benzenesulfinate, and sodium toluenesulfinate. In another embodiment the metallocene compound was used in conjunction with Eosin Y or 2',4',5',7'-Tetrabromofluorescein acid to enhance its reactivity to photons emitted from the green pixels.

It was found desirable to use a metallocene composition containing bis(.eta.5-2,4-cylcopentadien-1-yl)-bis(2,6-difluoro-3-(1H-pyrrol-1-yl)-phenyl) titanium.

In certain embodiments, the composition further comprises one or more performance-enhancing additives including, for example, esters of acrylic or methacrylic acid, stabilisers, defoamers, dyes and high molecular weight fatty acids. Examples of fatty acids which are particularly effective in ensuring a dry, tack-free surface after post-curing of the washed plate include, for example, myristic acid.

### Examples

Various aspects of the invention will now be particularly described with reference to the following examples:

### Example 1 - Exemplary apparatus and method

A 3D printer was constructed in the following manner, a central processing unit was programmed with the driver software and connected to a drive motor that vertically raised or declined a platform by small increments, typically 0.1mm. The image to be printed was a detailed chess piece which was scanned using 3D scanning software such as reconstructme.net from Profactor and created using Google SketchUp from Google Inc. The resultant computer image file was stored in stereolithography format (STL).

The image was split into slices that were 0.1mm thick and these images were sent sequentially to the screen as black and white files. The length of time the image was displayed on the screen, the illuminating time, was a constant for all the image slices after the first layer. This was calculated as the time required for the chosen screen to polymerise 0.1mm of the liquid polymer.

A VGA type 4:3 resolution 8" LCD colour monitor with VGA BNC AV Port, manufactured by Samsung was used, this screen provided a 800 (horizontal) x 600 pixel resolution (vertical) with a viewing area of 162mm wide by 121.5mm high and a viewing angle of 130 degrees high by 115 degrees vertically. The brightness of the screen was 300cd/sqm.

To create a release layer on the surface of the LCD screen a total of 60g of Silguard 184 manufactured by Dow, a 2 part reactive silicone, was mixed thoroughly, de-aerated and poured over the screen to create a low surface energy surface for easy detachment of the polymer from the screen. This gave a thickness of 1mm evenly cured over the screen. The screen was left at 40C for 48 hours to fully cure.

A flat aluminium platform 75mm x 45mm perforated with holes was mounted onto a belt driven motor so that it could be raised and lowered in the vertical plane by increments of 0.1mm. An open-topped and open-bottomed polymer containment vessel or vat was sealed around the edge of the top of the LCD screen which could contain liquid in a leak-proof manner. The vat was large enough to take the print platform.

500g of the light polymerisable compound was composed in the following manner. A glass vessel was loaded with 325g of Genomer 4302, an aliphatic polyester triurethane, manufactured by Rahn AG of Switzerland, 130g of TEDGMA (triethylene dimethacrylate) a reactive diluent manufactured by Sartomer under the trade SR205 to it, 40g of TMPTMA (trimethylolpropane trimethacrylate) a reactive diluent manufactured by Sartomer under the trade SR350 and 5.0g of (bis(.eta.5-2,4-cylcopentadien-1-yl)-bis(2,6-difluoro-3-(1H-pyrrol-1-yl)-phenyl) titanium) a photoinitiator manufactured by BASF under the trade name Irgacure 784. They were mixed at 60 °C for a total of 3 hours and allowed to cool.

The photopolymer liquid was poured into the vat. The print platform with the adhesive sheet on, with its sticky side facing down, was lowered down onto the screen and this point was taken as the zero point. It was then backed off by 0.5mm by the motor and the first exposure was commenced. The first image was an extended exposure time to ensure that any fine detail is formed and adhered to the print platform. This first time was set to 2 minutes. After this the normal exposure cycle was started.

The print platform was lowered from its previous exposure position by 0.5mm to allow polymer to re-fill the cavity. It can be lowered in the motor's fast setting to save time. The motor then stopped and reversed to bring the platform back up to the same position as before, but 0.1mm lower, i.e. a reversal of 0.4mm. The second image was exposed on the screen for 15 seconds, the print platform was again lowered by 0.5mm and the process repeated.

The 3D printer could be positioned in two orientations, with the LCD screen at the top with the build platform below where the platform moves sequentially lower and further away from the screen as the image grows. It could also be positioned with the LCD screen at the bottom with the build platform above it where the build platform moves upwards away from the LCD screen. In both formats the build platform is immersed in a vat of liquid polymer.

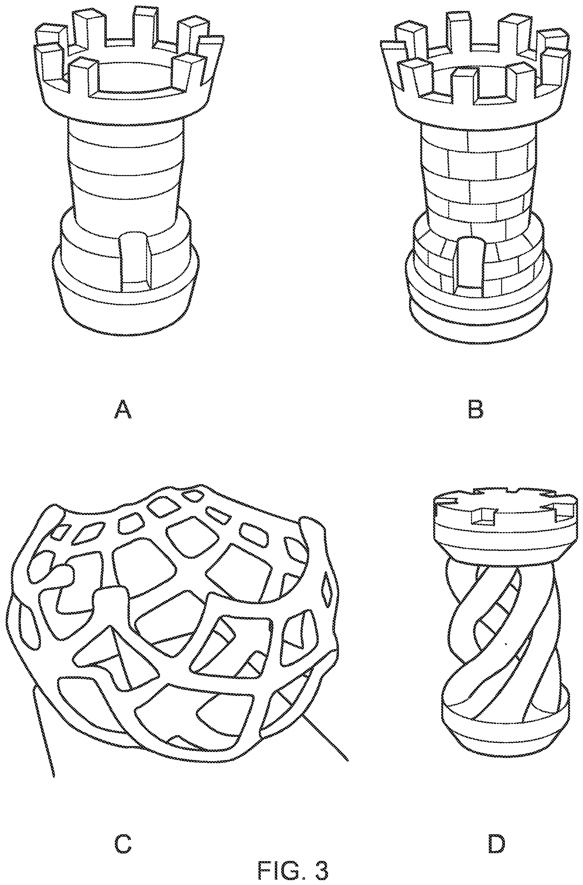

Thus the image could be formed in layers, each one being created in proximity to the screen. The print platform is then moved away by a multiple of the layers or separation distance and the cavity created is replaced by liquid polymer. This method is repeated until the final slice of the image was exposed and the image is completed. The print platform and 3D object was removed from the polymer vat. The 3D image was washed in water and detergent to remove liquid polymer and was treated to post treatment of 10 minutes post curing by immersing the object in water and subjecting it to UV exposure of an intensity of 1.5mW/cm2. The chess piece was composed of 657 0.1mm layers and is shown in Figure 3A.

While a satisfactory image was generated using the above conditions, at a level of curing that would be satisfactory for certain applications, the chess piece made in this example was found to be underexposed showing no evidence of the internal helical staircase for example. The above process was repeated, except the layer exposure time was set to 55 seconds. This resulted in a perfectly exposed version of the tower showing the external brickwork and the internal staircase and helix as shown in Figure 3B.

### Example 2 - Faster formulation

To investigate the optimised rate of growth of the polymer under LCD illumination with different levels of addition of bis(.eta.5-2,4-cylcopentadien-1-yl)-bis(2,6-difluoro-3-(1H-pyrrol-1-yl)-phenyl) titanium (titanocene made by BASF under the tradename Irgacure 784), 500g of a standard polymer formulation was made to test it in. A glass vessel was loaded with 325g of Genomer 4302, an aliphatic polyester triurethane, manufactured by Rahn AG of Switzerland, 130g of TEDGMA (triethylene dimethacrylate) a reactive diluent manufactured by Sartomer under the trade SR205 to it, 45g of TMPTMA (trimethylolpropane trimethacrylate) a reactive diluent manufactured by Sartomer under the trade SR350. To this, the following percentages of bis(.eta.5-2,4-cylcopentadien-1-yl)-bis(2,6-difluoro-3-(1H-pyrrol-1-yl)-phenyl) titanium) were separately added, 0.1%, 0.2%, 0.3%. 0.4%, 0.5%, 0.6%, 0.7%, 0.8%, 0.9%, 1.0%, 1.1%, 1.2%, 1.3%, 1.4% and 1.5%. Each composition was mixed at 60 °C for a total of 3 hours and allowed to cool.

Each compound was filled into the vat and using the standard 3D method described in example 1, the amount of time required to fully create a 1mm build layer was found.

This time was the minimum time to create a layer successfully and was found by iterative experimentation. These results are shown in tabular format in Table 1 below:

**Effect of varying addition concentration of Titanocene with time**

| % addition of Titanocene | Minimum time to hold detail at 0.1mm thickness (underexposed) | Time to hold all possible detail at 0.1mm thickness |
|---|---|---|
| 0.1 | 42 | 175 |
| 0.2 | 27 | 152 |
| 0.3 | 21 | 129 |
| 0.4 | 18 | 116 |
| 0.5 | 16 | 97 |
| 0.6 | 19 | 85 |
| 0.7 | 22 | 73 |
| 0.8 | 25 | 69 |
| 0.9 | 29 | 55 |
| 1 | 34 | 57 |
| 1.1 | 39 | 67 |
| 1.2 | 45 | 77 |
| 1.3 | 48 | 80 |
| 1.4 | 50 | 90 |
| 1.5 | 60 | 100 |

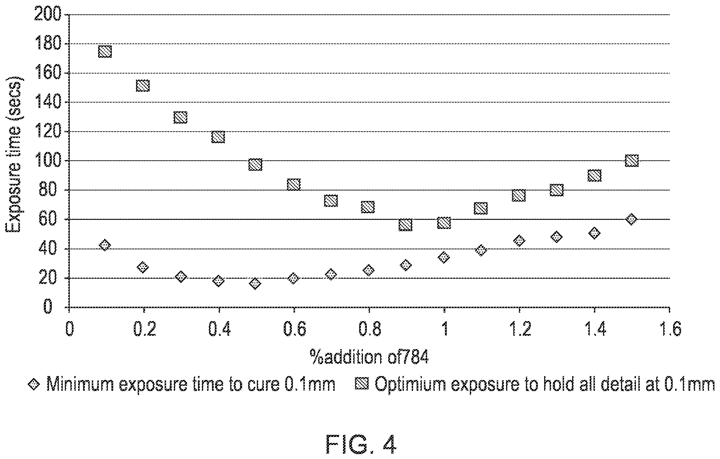

These results are shown in graphical format in **FIG 4****.**

It was found that the optimal rate of cure was obtained when approximately 0.9% of the photopolymer was the initiator.

### Example 3-. Silicone coated screen

500g of the light polymerisable compound was composed in the following manner. A glass vessel was loaded with 325g of Genomer 4302, an aliphatic polyester triurethane, manufactured by Rahn AG of Switzerland, 130g of TEDGMA (triethylene dimethacrylate) a reactive diluent manufactured by Sartomer under the trade SR205 to it, 41.25g of TMPTMA (trimethylolpropane trimethacrylate) a reactive diluent manufactured by Sartomer under the trade SR350 and 3.75g of (bis(.eta.5-2,4-cylcopentadien-1-yl)-bis(2,6-difluoro-3-(1H-pyrrol-1-yl)-phenyl) titanium) a photoinitiator manufactured by BASF under the trade name Irgacure 784. They were mixed at 60 °C for a total of 3 hours and allowed to cool.

The LCD screen was a VGA type 4:3 resolution 8" LCD colour monitor with VGA BNC AV Port, manufactured by Samsung. It provided a 800 (horizontal) x 600 pixel resolution (vertical) with a viewing area of 162mm wide by 121.5mm high and a viewing angle of 130 degrees high by 115 degrees vertically. The brightness of the screen was 300cd/sqm.

A release layer for the LCD screen was created covering it with a suitable curable silicone compound. A total of 60g of Silgaurd 184, a 2 part reactive silicone, manufactured by Dow Corporation was mixed thoroughly, de-aerated and poured over the LCD screen to create a low surface energy surface for easy detachment of the polymer from the screen. This provided a 1mm thickness of silicone evenly cured over the screen. The screen was left at 40C for 48 hours to fully harden and be dry to touch.

A flat aluminium platform 75mm x 45mm perforated with holes was mounted to a belt driven motor so that it could be elevated and declined in the vertical plane by increments of 0.1mm.

A total of 16.9g of the photopolymer was poured in a tray the size of the print platform. It was cured with daylight to form a level solid sheet of exposed polymer. It was not post exposed under water, so the upper surface contained open, not fully cross-linked chains. This sheet was attached to the print platform using 9088 double sided tape manufactured by 3M Corporation.

An open-topped and open-bottomed polymer containment vat was made from Perspex (trademark of Dupont) to the inner dimensions of the screen. It was sealed around its base to the top of the LCD screen with the same silicone, such that it could contain the liquid polymer in a leak-proof manner. The container was large enough to take the print platform and elevate it to a total of 10cm high.

500g of the photopolymer liquid was poured into the container. The print platform with the adhesive sheet on, with the sticky side facing down, was lowered down onto the screen and this point was taken as the starting or zero point.

The object to be printed was an open lattice of a sphere. It was scaled by a half of its original size so that the final object would be 5cm in diameter, comfortably within the dimensions of the print platform. The print platform was then moved 0.5mm away from the screen and the first exposure was started. The first exposure was an extended exposure time to ensure that any fine detail is formed and successfully adhered. This first time was set to 2 minutes. After this the normal exposure cycle commenced.

The print platform was lowered from its previous exposure position by 0.5mm to allow polymer to re-fill the cavity. It was lowered in the motor's fast setting to save time. The motor then stopped and reversed to bring the platform back up to the same position as before, but 0.1mm lower, i.e. a reversal of 0.4mm. The second image was exposed on the screen for 24 seconds, and the process was repeated.

A total of 347 layers were made and the resultant 3D image created was shown in Figure 3C.

While a satisfactory image was generated using the above conditions, at a level of curing that would be satisfactory for certain applications, the sphere made in this example was found to be underexposed for many applications.

### Example 4 Using FEP film instead of silicone

500g of the light polymerisable compound was composed in the following manner. A glass vessel was loaded with 325g of Genomer 4302, 130g of TEDGMA to it, 40.5g of TMPTMA and 4.5g of titanocene They were mixed at 60°C for a total of 3 hours and allowed to cool.

The LCD screen was a VGA type 4:3 resolution 8" LCD colour monitor with VGA BNC AV Port. It provided a 800 (horizontal) x 600 pixel resolution (vertical) with a viewing area of 162mm wide by 121.5mm high and a viewing angle of 130 degrees high by 115 degrees vertically. The brightness of the screen was 400cd/sqm.

An open bottomed rectangular tray of base dimensions 162mm by 121.5mm was constructed from 4mm thick clear cast acrylic sheet, the sheet was 100mm wide, creating the depth of the vat. A sheet of 12 µm FEP film, manufactured by Dupont, was sealed around the frame to leave a taught, sealed base of the film. It could be sealed with adhesive, solvent or ultrasonic welding or adhesive tape. This tray was placed on top of the screen so that the clear film was resting on the LCD screen.

A flat aluminium platform 75mm x 45mm perforated with holes was mounted to a belt driven motor so that it could be elevated and declined in the vertical plane by increments of 0.1mm.

A total of 500g of the photopolymer was poured into the tray. The print platform was lowered down onto the screen and this point was taken as the starting or zero point.

The object to be printed was a cylindrical spiral shape. The print platform was then elevated 0.1mm away from the screen and the first exposure was started. The first exposure was an extended exposure time to ensure that any fine detail is formed and successfully adhered. This first time was set to 5 minutes. After this the normal exposure cycle commenced.

The print platform was raised from its previous exposure position by 0.5mm to allow polymer to re-fill the cavity. It was lowered 0.4mm to leave it 0.1mm away from the screen. The second image was exposed on the screen for 55 seconds, and the process was repeated.

A total of 454 layers were made and the resultant 3D image created was shown in Figure 3D.

### Example 5.- Faster curing

To make a 3D object faster, a more active daylight was developed. 500g of this daylight polymerisable compound was made by taking 190g of Genomer 4302, an aliphatic polyester triurethane, 135g of Genomer 4269 a urethane acrylate manufactured by Rahn AG of Switzerland, 150g of HDDA (Hexane-1,6-diol diacrylate) a difunctional reactive monomer made by Rahn under the name Miramer M200, adding 22.75g of TMPTMA (trimethylolpropane trimethacrylate) a reactive diluent manufactured by Sartomer under the trade SR350 and 2.25g of (bis(.eta.5-2,4-cylcopentadien-1-yl)-bis(2,6-difluoro-3-(1H-pyrrol-1-yl)-phenyl) titanium) manufactured by BASF under the trade name Irgacure 784. They were all added to a glass mixing vessel and were mixed at 60C for a total of 3 hours and allowed to cool.

The LCD screen, 3D printing apparatus and procedure of operation was the same as in Example 3. The object to be printed was a scale model of the 101 Tower in Taipei. The print platform was moved 0.5mm away from the screen to create a larger first layer to ensure that any fine detail is formed and adhered to the print platform. This first time was set to 90 secs. After this the normal exposure cycle commenced.

The print platform was lowered from its previous exposure position by 0.5mm to allow polymer to re-fill the cavity. It can be lowered in the motor's fast setting to save time. The motor then stopped and reversed to bring the platform back up to the same position as before but 0.1mm lower, i.e. a reversal of 0.4mm. The second image was exposed on the screen for 15 seconds, and the process was repeated.

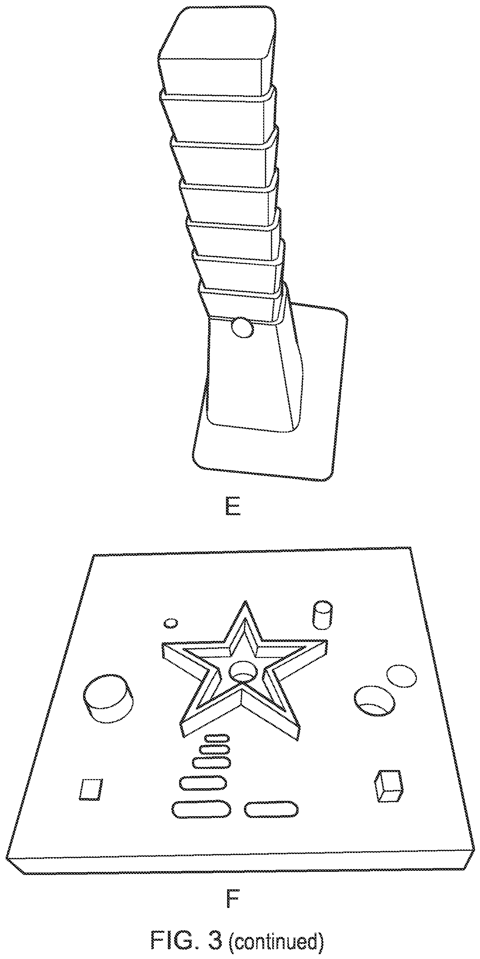

A total of 397 layers were made and the resultant 3D image created was shown in Figure 3E.

While a satisfactory image was generated using the above conditions, at a level of curing that would be satisfactory for certain applications, the tower made in this example was found to be underexposed for many applications.

### Example 6.- Finer resolution

It is possible to make objects with finer resolution if the layer thickness is thinner, in practice the limiting factor here is not the chemistry of the resin, but the accuracy of the engineering of the z-axis. This was demonstrated by making a high resolution test piece at 0.05mm layers. 500g of the daylight polymerisable compound used in example 4 was made.

The LCD screen, 3D printing apparatus and procedure of operation was the same as in Example 4. The object to be printed was a test plate with fine dots and lines. The print platform was moved 0.1mm away from the screen to create a larger first layer to ensure that any fine detail is formed and adhered to the print platform. This first time was set to 5 mins. After this the normal exposure cycle commenced.

The print platform was raised from its previous exposure position by 0.5mm to allow polymer to re-fill the cavity. It was then lowered by 0.45mm, ie a separation of 0.05mm or 50µm. The second image was exposed on the screen for 28 seconds, and the process was repeated.

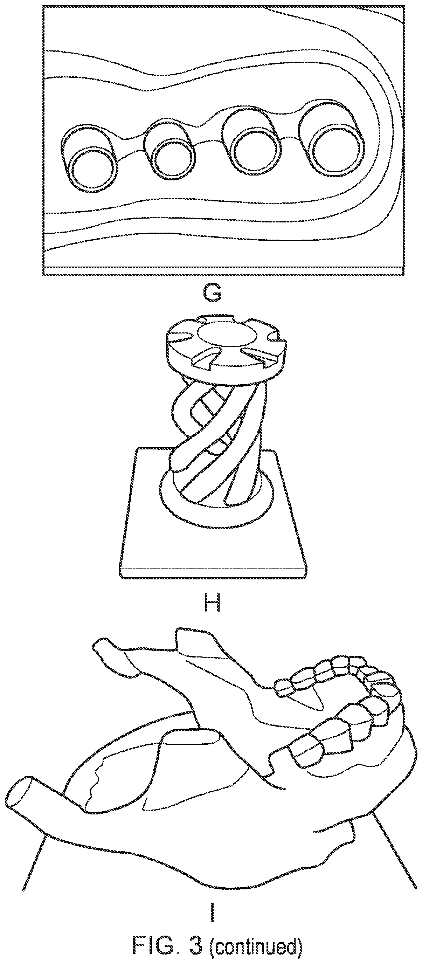

The resultant 3D image created was shown in Figures 3F and Figure 3G which is enlarged 200 times. The x:y resolution obtained was µm, the 0.05mm wide lines and 0.05mm diameter cylinders have all been held. This gives an overall resolution of µm.

### Example 7. - lower shrinkage

An adaption of the photopolymer formulation was made to exhibit lower shrinkage with the optimisation of reactive monomers and reactive acrylates. 500g of this daylight polymerisable compound was made by taking 325g of Genomer 4188, a high elongation and stress break, low yellowing acrylate manufactured by Rahn AG of Switzerland, 172.75g of TEDGMA (triethyleneglycol dimethacrylate) a difunctional reactive monomer and 2.25g of (bis(.eta.5-2,4-cylcopentadien-1-yl)-bis(2,6-difluoro-3-(1H-pyrrol-1-yl)-phenyl) titanium) manufactured by BASF under the trade name Irgacure 784. They were all added to a glass mixing vessel and were mixed at 60C for a total of 3 hours and allowed to cool.

The LCD screen, 3D printing apparatus and procedure of operation was the same as in Example 4. The object to be printed was a tower. The print platform was moved 0.5mm away from the screen to create a larger first layer to ensure that any fine detail is formed and adhered to the print platform. This first time was set to 1 minute. After this the normal exposure cycle commenced.

The print platform was lowered from its previous exposure position by 0.5mm to allow polymer to re-fill the cavity. It can be lowered in the motor's fast setting to save time. The motor then stopped and reversed to bring the platform back up to the same position as before but 0.1mm lower, i.e. a reversal of 0.4mm. The second image was exposed on the screen for 18 seconds, and the process was repeated.

A total of 230 layers were made and the resultant 3D image created was shown in Figure 3H.

While a satisfactory image was generated using the above conditions, at a level of curing that would be satisfactory for certain applications, the tower made in this example was found to be underexposed for many applications.

### Example 8

An alternative LCD screen was demonstrated using a versatile polymer with low shrinkage and fast rate of cure. 500g of this daylight polymerisable compound was made by taking 215g of Genomer 4188, a high elongation and stress break, low yellowing acrylate manufactured by Rahn AG of Switzerland, 119.25g of Genomer 4302, an aliphatic polyester triurethane, manufactured by Rahn AG of Switzerland 163.5 of TEDGMA (triethyleneglycol dimethacrylate) a difunctional reactive monomer and 2.25g of (bis(.eta.5-2,4-cylcopentadien-1-yl)-bis(2,6-difluoro-3-(1H-pyrrol-1-yl)-phenyl) titanium) manufactured by BASF under the trade name Irgacure 784. They were all added to a glass mixing vessel and were mixed at 60 °C for a total of 3 hours and allowed to cool.

The LCD screen was a 7" photo display screen made by Lumina. This had a display providing 480 x 234 pixels, a screen size of 15.8cm x 8.7 cm (6.2 inches x 3.4inches) with a viewing angle of 60° vertically and 40° horizontally and a brightness of 200 cd/m². The 3D printing apparatus and procedure of operation was the same as in Example 5. The object to be printed was a lower human jaw or mandible. The print platform was moved 0.5mm away from the screen to create a larger first layer to ensure that any fine detail is formed and adhered to the print platform. This first time was set to 2 minutes. After this the normal exposure cycle commenced.

The print platform was lowered from its previous exposure position by 0.5mm to allow polymer to re-fill the cavity. It can be lowered in the motor's fast setting to save time. The motor then stopped and reversed to bring the platform back up to the same position as before but 0.1mm lower, i.e. a reversal of 0.4mm. The second image was exposed on the screen for 21 seconds, and the process was repeated.

A total of 272 layers were made and the resultant 3D image created was shown in Figure 3I.

While a satisfactory image was generated using the above conditions, at a level of curing that would be satisfactory for certain applications, the jaw made in this example was found to be underexposed for many applications.

## Claims

1. A 3D printer comprising:
a visual display screen; wherein no more than 5% of the light emitted by the screen is UV light;
a vat for liquid photopolymer;
a build platform having a build surface for use in the vat whilst stereolithographically printing a 3D object; and
an actuator for varying the separation of the build surface and the visual display screen;
wherein the visual display screen is situated outside the vat whilst printing a 3D object, and
wherein the vat is transparent to at least part of the spectrum of light that is visible to the human eye or comprises a window that is transparent to at least part of the spectrum of light that is visible to the human eye.

2. A 3D printer of claim 1, comprising:
an image processor configured to control the visual display screen to display a sequence of photolithographic images; and
an actuation controller configured to control the actuator;
wherein the image processor and actuation controller are configured to communicate to synchronise the display of photolithographic images and the varying the separation of the build surface and the visual display screen.

3. A 3D printer of claim 2, wherein the actuation controller is configured to monotonically increase the separation of the build surface and the visual display screen between successive stereolithographic exposures by a distance corresponding with a layer thickness of a 3D object to be printed.

4. A 3D printer of claim 2, wherein the actuation controller is configured to increase the separation of the build surface and the visual display screen between successive stereolithographic exposures by a distance greater than a layer thickness of a 3D object to be formed, and subsequently to reduce the separation by a second distance to provide a net increase in separation corresponding with a layer thickness of a 3D object to be formed.

5. A 3D printer of any one of claims 1 to 4, wherein the visual display screen is a liquid crystal display screen (LCD); optionally wherein the visual display screen is a single LCD screen.

6. A 3D printer of claim 5, wherein the visual display screen is backlit by LEDs.

7. A 3D printer of any one of claims 1 to 4, wherein the visual display screen is selected from a light emitting diode type (LED), an organic light emitting diode type (OLED), a polymer light emitting diode type (PLED), an electroluminescent display type (ELD), and a plasma display panel type (PDP).

8. A 3D printer any one of claims 1 to 7, wherein the visual crystal display screen is the screen of a device selected from television, computer, tablet computer and mobile phone.

9. A 3D printer of any one of claims 1 to 8, wherein none of the light emitted by the screen is UV light.

10. A 3D printer any one of claims 1 to 9, wherein the visual display screen has a luminescence of between 100 and 2000 candela per square metre.

11. A method for creating a 3-dimensional object, the method being performed on a 3-D printer of any one of claims 1 to 10, the method comprising forming more than two layers of a cured polymer by exposing liquid photopolymer to light emitted by the visual display screen and wherein the photopolymer contains a visible light photoinitiator, the photoinitiator being organometallic or metallocene.

12. A method of any one of claim 11, wherein the photoinitiator is a titanocene.

13. A method of claim 12, wherein the photoinitiator is bis(.eta.5-2,4-cylcopentadien-1-yl)-bis(2,6-difluoro-3-(1H-pyrrol-1-yl)-phenyl) titanium.

14. A method of any one of claims 11 to 13, wherein at least three adjacent layers of the cured polymer are not superimposed.

## Patentansprüche

1. 3D-Drucker, umfassend:
einen visuellen Anzeigebildschirm; wobei höchstens 5 % des vom Bildschirm ausgegebenen Lichts UV-Licht ist;
eine Wanne für flüssigen Photopolymer;
eine Bauplattform mit einer Bauoberfläche zur Verwendung in der Wanne während des stereolithographischen Druckens eines 3D-Objekts;
und ein Betätigungselement zum Variieren des Trennabstands der Bauoberfläche und des visuellen Anzeigebildschirms;
wobei der visuelle Anzeigebildschirm während des Druckens eines 3D-Objekts außerhalb der Wanne angeordnet ist und
wobei die Wanne mindestens gegenüber einem Teil des Lichtspektrums, der für das menschliche Auge sichtbar ist, transparent ist oder ein Fenster umfasst, das mindestens gegenüber einem Teil des Lichtspektrums, der für das menschliche Auge sichtbar ist, transparent ist.

2. 3D-Drucker nach Anspruch 1, umfassend:
einen Bildprozessor, der konfiguriert ist, um den visuellen Anzeigebildschirm zu steuern, um eine Abfolge photolithographischer Bilder anzuzeigen;
und eine Betätigungssteuerung, die konfiguriert ist, um das Betätigungselement zu steuern;
wobei der Bildprozessor und die Betätigungssteuerung konfiguriert sind, um zu kommunizieren, um die Anzeige photolithographischer Bilder und das Variieren des Trennabstands der Bauoberfläche und des visuellen Anzeigebildschirms zu steuern.

3. 3D-Drucker nach Anspruch 2, wobei die Betätigungssteuerung konfiguriert ist, um den Trennabstand der Bauoberfläche und des visuellen Anzeigebildschirms zwischen aufeinanderfolgenden stereolithographischen Expositionen um einen Abstand monoton zu erhöhen, der einer Schichtdicke eines zu druckenden 3D-Objekts entspricht.

4. 3D-Drucker nach Anspruch 2, wobei die Betätigungssteuerung konfiguriert ist, um den Trennabstand der Bauoberfläche und des visuellen Anzeigebildschirms zwischen aufeinanderfolgenden stereolithographischen Expositionen um einen Abstand zu erhöhen, der größer als eine Schichtdicke eines zu formenden 3D-Objekts ist, und anschließend den Trennabstand um einen zweiten Abstand zu verringern, um eine Nettoerhöhung im Trennabstand bereitzustellen, die einer Schichtdicke eines zu formenden 3D-Objekts entspricht.

5. 3D-Drucker nach einem der Ansprüche 1 bis 4, wobei der visuelle Anzeigebildschirm ein Flüssigkristallanzeigebildschirm (Liquid Crystal Display, LCD) ist; optional wobei der visuelle Anzeigebildschirm ein einzelner LCD-Bildschirm ist.

6. 3D-Drucker nach Anspruch 5, wobei der visuelle Anzeigebildschirm durch LEDs hintergrundbeleuchtet wird.

7. 3D-Drucker nach einem der Ansprüche 1 bis 4, wobei der visuelle Anzeigebildschirm ausgewählt ist aus einem der folgenden Typen: LED (Light Emitting Diode), OLED (Organic Light Emitting Diode), PLED (Polymer Light Emitting Diode), ELD (Electroluminescent Display) und PDP (Plasma Display Panel).

8. 3D-Drucker nach einem der Ansprüche 1 bis 7, wobei der visuelle Kristallanzeigebildschirm der Bildschirm eines Geräts ist, ausgewählt aus Fernseher, Computer, Tablet-Computer und Mobiltelefon.

9. 3D-Drucker nach einem der Ansprüche 1 bis 8, wobei nichts von dem vom Bildschirm ausgegebenen Licht UV-Licht ist.

10. 3D-Drucker nach einem der Ansprüche 1 bis 9, wobei der visuelle Anzeigebildschirm eine Lumineszenz von zwischen 100 bis 2000 Candela pro Quadratmeter hat.

11. Verfahren zum Schaffen eines dreidimensionalen Objekts, wobei das Verfahren auf einem 3D-Drucker nach einem der Ansprüche 1 bis 10 ausgeführt wird, wobei das Verfahren umfasst Formen von mehr als zwei Schichten eines ausgehärteten Polymers durch Exponieren von flüssigem Photopolymer gegenüber Licht, das vom visuellen Anzeigebildschirm ausgegeben wird, und wobei das Photopolymer einen Photoinitiator für sichtbares Licht enthält, wobei der Photoinitiator organometallisch oder metallocen ist.

12. Verfahren nach einem der Ansprüche 11, wobei der Photoinitiator Titanocen ist.

13. Verfahren nach Anspruch 12, wobei der Photoinitiator Bis(.eta.5-2,4-cylcopentadien-1-yl)-bis(2,6-difluor-3-(1H-pyrrol-1-yl)-phenyl)-titan ist.

14. Verfahren nach einem der Ansprüche 11 bis 13, wobei mindestens drei angrenzende Schichten des ausgehärteten Polymers nicht übereinandergelagert sind.

## Revendications

1. Imprimante 3D comprenant :
un écran de visualisation ; pas plus de 5 % de la lumière émise par l'écran étant une lumière ultraviolette (UV) ;
une cuve pour photopolymère liquide ;
une plate-forme de construction possédant une surface de construction destinée à être utilisée dans la cuve lors de l'impression par stéréolithographie d'un objet 3D ;
et un actionneur destiné à faire varier l'espacement de la surface de construction et de l'écran de visualisation ;
ledit écran de visualisation étant situé à l'extérieur de la cuve lors de l'impression d'un objet 3D, et ladite cuve étant transparente pour au moins une partie du spectre de la lumière visible à l'oeil humain ou comprenant une fenêtre qui est transparente pour au moins une partie du spectre de la lumière visible à l'oeil humain.

2. Imprimante 3D selon la revendication 1, comprenant :
un processeur d'image configuré pour commander l'écran de visualisation afin d'afficher une séquence d'images photolithographiques ;
et un dispositif de commande d'actionnement configuré pour commander l'actionneur ; ledit processeur d'images et ledit dispositif de commande d'actionnement étant configurés pour communiquer afin de synchroniser l'affichage d'images photolithographiques et la variation de l'espacement de la surface de construction et de l'écran de visualisation.

3. Imprimante 3D selon la revendication 2, ledit dispositif de commande d'actionnement étant configuré pour augmenter de façon monotone l'espacement de la surface de construction et de l'écran de visualisation entre des expositions stéréolithographiques successives d'une distance correspondant à une épaisseur de couche d'un objet 3D à imprimer.

4. Imprimante 3D selon la revendication 2, ledit dispositif de commande d'actionnement étant configuré pour augmenter l'espacement de la surface de construction et de l'écran de visualisation entre des expositions stéréolithographiques successives d'une distance supérieure à une épaisseur de couche d'un objet 3D à former, et ensuite pour réduire l'espacement d'une seconde distance pour fournir une augmentation nette de l'espacement correspondant à une épaisseur de couche d'un objet 3D à former.

5. Imprimante 3D selon l'une quelconque des revendications 1 à 4, ledit écran de visualisation étant un écran de visualisation à cristaux liquides (LCD) ; éventuellement ledit écran de visualisation étant un seul écran LCD.

6. Imprimante 3D selon la revendication 5, ledit écran de visualisation étant rétroéclairé par des diodes électroluminescentes (DEL).

7. Imprimante 3D selon l'une quelconque des revendications 1 à 4, ledit écran de visualisation étant choisi parmi un type de diode électroluminescente (DEL), un type de diode électroluminescente organique (DELO), un type de diode électroluminescente à polymère (DELP), un type d'affichage électroluminescent (ELD), et un type de panneau d'affichage à plasma (PDP).

8. Imprimante 3D selon l'une quelconque des revendications 1 à 7, ledit écran d'affichage à cristaux liquides étant l'écran d'un dispositif choisi parmi une télévision, un ordinateur, une tablette informatique et un téléphone mobile.

9. Imprimante 3D selon l'une quelconque des revendications 1 à 8, aucune lumière émise par l'écran n'étant une lumière UV.

10. Imprimante 3D selon l'une quelconque des revendications 1 à 9, ledit écran de visualisation possédant une luminescence comprise entre 100 et 2000 candelas par mètre carré.

11. Procédé permettant la création d'un objet tridimensionnel, ledit procédé étant mis en oeuvre sur une imprimante 3D selon l'une quelconque des revendications 1 à 10, ledit procédé comprenant la formation de plus de deux couches d'un polymère durci en exposant le photopolymère liquide à la lumière émise par l'écran de visualisation et ledit photopolymère contenant un photoinitiateur à lumière visible, ledit photoinitiateur étant organométallique ou métallocène.

12. Procédé selon l'une quelconque des revendications 11, ledit photoinitiateur étant du titanocène.

13. Procédé selon la revendication 12, ledit photoinitiateur étant le bis(.eta.5-2,4-cyclcopentadiène-1-yl)-bis(2,6-difluoro-3-(1H-pyrrol-1-yl)-phényle) titane.

14. Procédé selon l'une quelconque des revendications 11 à 13, au moins trois couches adjacentes du polymère durci n'étant pas superposées.
